# EUROPEAN PATENT SPECIFICATION

(11) **EP 0 497 616 B1**
(45) Date of publication and mention of the grant of the patent: **07.07.1999**
(21) Application number: 92300845.2
(22) Date of filing: 31.01.1992
(51) Int. Cl.: G01R 31/36, G01R 13/40, H01M 10/48

(54) **Electrochromic cell testers**
Elektrochrome Prüfvorrichtungen für Batterien
Testeurs électrochromes de pile

(30) Priority: 31.01.1991 US 648080
(43) Date of publication of application: 05.08.1992
(73) Proprietor: EVEREADY BATTERY COMPANY, INC., St. Louis Missouri 63164 (US)
(72) Inventor: Bailey, John C., Columbia Station, OH 44028 (US)
(74) Representative: Lord, Hilton David

(56) References cited:
- EP-A- 0 450 938
- DE-A- 3 150 480
- US-A- 4 723 656
- PATENT ABSTRACTS OF JAPAN vol. 9, no. 203 (P-381)21 August 1985 & JP-A-60 066 170 ( HITACHI MAXELL ) 16 April 1985
- PATENT ABSTRACTS OF JAPAN vol. 11, no. 112 (P-565)9 April 1987 & JP-A-61 261 724 ( ALPS ELECTRIC ) 19 November 1986

## Description

The present invention relates to an electrochemical cell and a state-of-charge tester therefor.

With typical dry cells or batteries, a user cannot tell from looking at them whether they have little useful life left or whether they are fresh. A completely discharged battery and a new one present the same physical appearance. To determine the usefulness of a battery, it might be considered that simply putting the battery into a device and operating the device would provide an indication of charge. Very few devices, however, work with only one battery and, if a new battery and a discharged battery, or a nearly discharged battery, are put into a device such as a flashlight, the flashlight will glow very dimly, if at all. The conclusion, then, would be that the batteries are all defective and should be replaced when, in fact, one of the batteries might be a fresh battery.

In order to test the cells, it is possible to use relatively expensive testing equipment, such as a voltameter or an ammeter, but this is an inordinate expense in comparison to the cost of a new set of batteries.

There are other proposals for testing batteries. For example, US-A-4,723,656 discloses a blister-type package for new batteries, with a battery condition indicator built into the blister portion of the package. The blister can be deformed to place the tester across the terminals of a battery to be tested. A thermochromic liquid crystal material is employed in the tester in combination with a wedge-shaped resistive element. As the current flows through the resistive element, a thermal front moves away from the narrowest portion of the wedge to an extent depending on the capacity of the battery. The effect of the thermal front moving can be seen in the liquid crystal layer in thermal contact with the resistive element.

Several patents have been issued to Robert Parker, for example, US-A-4,702,563, US-A-4,702,564, US-A-4,726,661 and US-A-4,737,020, all relating to the use of a heat generating pattern on a flexible substrate in combination with a thermochromic liquid crystal layer to determine the state of charge of a battery. Attempts have even been made to view the contents of the cell while in use and to detect a colour change in the working components of the cell to determine the state of the cell as disclosed, for example, in US-A-4,497,881.

US-A-3,667,039 discloses the use of liquid crystal materials in a closed cell having either a shaped electrode or a shaped cell in order to provide a field gradient across the liquid crystal material. The cell is then connected across the terminals of a battery and the state of the battery is seen by noting the location of a visible gradient in the liquid crystal material and reading from an accompanying scale the status of the battery.

US-A-4,835,476 discloses heat sensitive dye systems using organic materials such as crystal violet lactone in combination with other reactive materials to form compositions which decolorise on application of the heat produced by current flowing through a resistive element connected between the terminals of a battery. When the coating material decolorises, a scale beneath the coating becomes visible indicating the status of the battery.

Thus, previous state-of-charge testers have used thermochromic materials, that is, materials which undergo a change in colour or colour intensity on the application of heat. Since heat is used to change the colour of the material, it is important that the heat not be drawn away from the measuring device. It has, therefore, not been practical to employ such devices attached directly to the dry cell or battery to be tested. The large thermal mass presented by the battery acts as a heat sink drawing the heat away causing the measuring device to read inaccurately.

EP-A-569357, which falls under the terms of Art. 54(3) EPC, discloses a battery strength indicator secured to a chemical cell, in which the indicator device is an electrochromic material.

In a first aspect, the present invention provides an electrochemical cell and a state-of-charge tester therefor, wherein the tester is secured to the cell and comprises electrochromic material which changes colour according to the redox potential to which it is subject and which provides an indication of state-of-charge of the cell thereby, said electrochromic material being sandwiched between electrically conductive layers connectable with opposing terminals of the cell, the outermost layer permitting a user to visually determine the colorimetric state of the electrochromic material, the tester being comprised in a label for the cell and wherein a load resistor is placed across the electrochromic material.

Suitable electrochromic materials are well know in the art and many are mentioned herein. Others will be apparent to those skilled in the art.

In general, the electrochromic materials should be mounted such that a redox potential can be generated across the material to effect a change in colour. It is preferred that the material provides a large surface, or at least a clearly visible surface, so that the user can observe any colour change readily.

The electrochromic material will generally be flat, or in the form of a film. This serves two purposes. The first is to provide as little leverage as possible, so that the tester will not inadvertently be removed from the cell. The second is that a thin film provides less resistance, so that a lower redox potential is required to effect a colour change.

The film is preferably situated at or near the surface of the battery container, or at or near the surface of the battery cover, which serves to seal the container and provide one of the terminals. This will be referred to as the bottom of the battery hereinafter.

The film may be in direct contact with the container or cover (but not both), or it may be insulated therefrom, with a conductor connecting its underside to one terminal. The conductor is suitably in the form of a wire, and may contact the film directly, or may contact the film via an electrolyte, as may the relevant surface of the cell, as appropriate.

The upper surface of the electrochromic material should be in contact with a suitable electrode. Accordingly, it is necessary that at least part of the film is visible through the electrode. This may be achieved by various means, such as by using a transparent or translucent electrode or electrolyte, the electrolyte serving to contact a wire, for example, which then connects with a terminal. Alternatively, the electrode may be in the form of a fine matrix covering the film.

A switch may be employed to connect the tester when desired. Such switches will be apparent to those skilled in the art. If the tester is in permanent contact, then it is preferred to use an electrochromic material which drains a minimum of power from the cell, typically a solid material.

It is preferred to use several different electrochromic materials for the present invention, so that differing states of charge of the cell may be ascertained. Thus, electrochromic materials may be selected which change colour at different potentials. According to which or how many change colour will indicate the state of charge.

When such different indicators are used, then they may be disposed as desired. They may be disposed on top of one another in increasing order of activation, so that only one colour is ever visible, but the colour which is visible will indicate the state of charge. Alternatively, they may arrayed side by side, and the number or arrangement of different colours can be used to indicate state of charge. Other suitable arrangements will be apparent to those skilled in the art.

In the event that the indicators are disposed side by side, each indicator may be a separate tester if desired, and each may share conductors with another, or have its own conductors, again as desired.

If the indicator goes clear on activation, then this may be used to expose a message, if desired. Those indicators exposing a colour may be conformed so as to display a message of that colour, or may be beneath a mask which can show the message. Other suitable configurations will be apparent to those skilled in the art.

In accordance with the present invention, a combined battery and battery tester is provided. A housing contains the active components of the battery and has a pair of external terminals. A tester for the battery is disposed on the housing. The tester includes a working electrode comprising an electronic conductor and an electrochromic material that undergoes a visible change as a result of a redox chemical reaction. An ionically conducting electrolyte is in contact with the working electrode. A counter electrode is in electrical contact with the electrolyte layer. The visible change in the electrochromic material is visible through the working or counter electrode. A pair of electrical conductors are provided for connecting the working and counter electrodes to the external terminals of the battery for testing the battery.

The tester detects and measures the state of charge of the cell or battery. The tester employs an electrochromic material. The electrochromic material changes colour (change in light absorption) as the material changes oxidation state, a redox-type reaction, under the influence of a DC potential applied directly to the electrochromic material. The electrochromic material may be a solid, a solid in solution or a liquid in a liquid solution. Solution devices are sometimes referred to as electrochemichromic devices. The tester is applied to the battery housing in the label on the housing, to measure the state of charge of the cell. A load resistor is placed across the electrochromic material.

Preferred embodiments are as follows:

A combined battery and battery tester comprising:
a housing containing the active components of said battery and having a pair of external terminals;
a tester for said battery disposed on said housing, said tester including:
a working electrode comprising an electronic conductor and an electrochromic material that undergoes a visible change as the result of a redox chemical reaction;
an ionically conducting electrolyte in contact with said working electrode;
a counter electrode in electrical contact with said electrolyte layer wherein the change is visible as viewed through the working or counter electrode; and
a pair of electrically conductive members for connecting said working and counter electrodes to said external terminals of said battery for testing said battery, the tester being comprised in a label for the battery and wherein a load resistor is placed across the electrochromic material.

A combination as described, wherein the counter electrode and the working electrodes set the voltage range of the tester, and the counter electrode comprises a metal, a metal oxide, an organic conductor or an electrochromic material.

The electrochromic material may be an inorganic material, or an organic material.

Preferably, the electrochromic material is WO₃, MoO₃, TiO₂, SnO₂, Cr₂O₃, NiO₂, Mn₂O₃, MnO₂, Ag₂O or Prussian blue.

Alternatively, the electrochromic material is a thin film reaction product on the surface of an electrode resulting from the electrolysis of an aqueous mixture of potassium tungstate, K₃WO₄, and oxalic acid H₂C₂O₄.

The electrochromic material may be in solution in an electrolyte, such as wherein the organic material is a redox indicator as an electrolyte solution, and preferably wherein the organic materials include pH indicating materials which undergo colour change on reaction with an active component derived from the solvent.

The organic materials may be phenolphthalein, methyl violet, ethyl red, methylene blue, naphthol blue black, N,N-dimethylindoaniline and N,N'-diphenylbenzidine.

The electrochromic material may be a solution of an anodic compound and a cathodic compound in a suitable solvent with at least one of the compounds undergoing a substantial change in molar extension coefficient upon oxidation or reduction under the influence of an applied DC electrical potential.

The electrolyte may be a gel or a polymer electrolyte, for example.

Suitably, the tester includes a transparent cover and one of the working and the counter electrode is a transparent coating on the cover, preferably wherein one of the working and the counter electrodes is a transparent, thin coating of a metal and/or one or more metal oxides, and/or a doped substoichiometric oxide of indium, tin, cadmium or zinc and/or fluorine- or antimony-doped tin oxide.

Further preferred embodiments include:

A combination battery and battery tester comprising:
a housing containing the active materials of a battery;
a pair of spaced terminals on the housing for providing electrical connection with the active material in the housing;
a battery tester on the housing, the tester comprising:
a working electrode comprising an electronic conductor;
a layer of electrochromic material covering at least a portion of the surface of the electronic conductor; and
a transparent cover including a transparent conductive member on the inside of the transparent cover for contacting the electrochromic material and forming with the working electrode a closed electrochromic cell; and
a pair of conductors for connecting the electrochromic cell to the spaced terminals on the housing for determining the state of charge of the battery, the tester being comprised in a label for the battery and wherein a load resistor is placed across the electrochromic material.

The battery condition tester may comprise:
a base member;
a working electrode on one surface of the base member, the working electrode comprising an electronic conductor in electrical contact with an electrochromic material that will undergo a change in optical absorption as a result of a redox chemical reaction upon application of a DC potential;
an ionically conducting electrolyte in contact with the working electrode;
a counter electrode in electrical contact with the electrolyte;
a cover member for attachment to the base member for enclosing the tester and through which the electrochromic material can be viewed; and
a pair of electrically conductive members for contacting the working and counter electrodes for providing electrical connection to external terminals of a battery to be tested, the tester being comprised in a label for the battery and wherein a load resistor is placed across the electrochromic material.

One of the working and the counter electrodes may be a transparent conductive coating on the inside of the cover member: the electrochromic material may be a coating on the working electrode.

In general, other components may be as described above.

The counter first electrode may be metallic and with the working electrode determines the overall electrochromic cell potential, or the counter electrode may be a second electrochromic material.

One of the electrodes of the tester may be a load along which the potential decreases. The tester is included in a label on the battery to be tested.

There is also provided a battery and electrochromic state-of-charge tester for the battery comprising:
a housing for containing the active components of the battery;
an end cover for each end of the housing forming the external terminals for the battery;
at least one electrochromic state-of-charge indicator mounted on one of the end covers and in electrical contact therewith;
an electrical circuit means for connecting the opposite external terminal of the battery to the electrochromic state-of-charge indicator to apply a DC potential directly to the electrochromic material to cause the material to change optical absorption as the result of an oxidation/reduction reaction induced by the directly applied DC potential, the resulting visual appearance of the electrochromic material indicating the state of charge of the battery, the tester being comprised in a label for the battery and wherein a load resistor is placed across the electrochromic material.

There is further provided the combination of a battery and a label for the battery that includes a battery condition tester comprising:
a housing for containing the galvanically active components for the battery;
a pair of end covers for the housing to complete the battery and to form the external terminals for the battery;
a layer of material substantially covering the housing, the layer of material including on the outer surface thereof the graphics for forming a label;
a first electrically conductive material on a portion of the label forming the first electrode of the battery condition tester;
a layer of electrochromic material on the first electrically conductive material;
a second electrically conductive material on the electrochromic material forming the second electrode of the battery condition tester; an ionically conductive electrolyte in contact with the first and second electrodes; and
a pair of electrical conductors for connecting at least one of the first and second electrodes of the battery condition tester to the external terminals of the battery, wherein a load resistor is placed across the electrochromic material.

The combination preferably has at least one opening therein to allow the electrochromic layer to be seen, or the second electrically conductive layer is transparent to enable the electrochromic layer to be seen.

There is yet further provided a battery and label for the battery, the label including a battery condition tester comprising:
a battery having first and second external terminals;
a label on the battery;
a battery tester on the label, the battery tester including:
a first electrically conductive material on a portion of the label forming the first electrode of the battery condition tester;
an electrochromic material on the first electrically conductive material;
a second electrically conductive material on the electrochromic material forming the second electrode for the battery condition tester;
an ionically conductive electrolyte in contact with the first and second electrodes; and
a first and second electrical conductor on the label for electrically connecting the first and second electrodes of the battery condition tester to at least one of the external terminals on the battery, wherein a load resistor is placed across the electrochromic material.

In addition, there is provided a battery and a label for the battery including a battery condition tester comprising:
a substrate for the label;
graphics on the substrate forming a label;
a battery tester on the label, the battery tester including:
a first electrically conductive material on a portion of the label forming the first electrode of the battery condition tester;
an electrochromic material on the first electrically conductive material;
a second electrically conductive material on the electrochromic material forming the second electrode for the battery condition tester; an ionically conductive electrolyte in contact with the first and second electrode; and
a first and second electrical conductor on the label for electrically connecting the first and second electrodes of the battery condition tester to at least one of the external terminals on the battery, wherein a load resistor is placed across the electrochromic material.

A suitable method for preparing a label for a battery including a battery condition tester comprises the following steps:
providing a substrate;
forming on the substrate a pattern of electronically conductive material;
applying to the electronically conductive material an electrochromic material and an ionically conductive electrolyte;
applying to the electrochromic material and electrolyte a second electronically conductive material, one of the electronically conductive materials being a material through which the visible change in the electrochromic material can be viewed;
providing on the label electrically conductive means for connecting one of the electrically conductive materials of the battery condition tester to one external terminal of the battery and for connecting the other electronically conductive materials to the other external terminal of the battery, and placing a load resistor across the electrochromic material.

The method preferably includes the following step: mounting the label and the battery tester on the battery with at least one of the electrically conductive means in electrical contact with an external terminal on the battery.

Thus, the present invention provides a battery and tester for use in determining the voltage and state of charge of the battery. The tester is permanently mounted on the battery in a label and employs an electrochromic cell which changes visual appearance, for example, colour or intensity of colour when electrically connected across the terminals of a battery. The electrochromic cell undergoes an oxidation/reduction reaction on direct application of the DC potential of the battery. The colour of the electrochromic cell can be compared with a colour comparison chart to determine the condition of the battery. A load resistor is placed across the electrochromic material.

The tester can be permanently electrically connected to the battery or, preferably, can be connected momentarily to determine the state of the battery.

The present invention will now be further illustrated with respect to the accompanying drawings, in which Fig. 8 shows an embodiment in accordance with the present invention and Figs. 1-78 and 9-11 are for reference:
Fig. 1 is a schematic elevational view of a battery tester accompanied by a scale for comparing the colour of the indicating device and determining the state of charge of the cell;
Fig. 2 is a sectional view taken along the line II-II of Fig. 1;
Fig. 3 is a perspective view of a battery having the measuring device mounted on the housing;
Fig. 4 is a plan view of an end cover for a battery showing a pattern of measuring devices;
Fig. 5 shows an end cover with a single measuring device;
Fig. 6 is a plan view of an end cover having an elongated arcuate measuring device along with a battery status colour scale;
Fig. 7A is a simplified schematic of the electrochromic cell connected for an open circuit test of a battery;
Fig. 7B shows the simplified schematic of Fig. 7A with a switch added to isolate the measuring device from the cell;
Fig. 8 (invention) is a simplified schematic of a closed circuit measuring device;
Fig. 9 is a simplified schematic of a device employing a resistive load which is also an electrode of the electrochromic cell;
Fig. 10 is a partial elevational view of a label for a battery including a printed battery condition testing device; and
Fig. 11 is a partial sectional view showing the label and battery condition testing device of Fig. 10 applied to a battery.

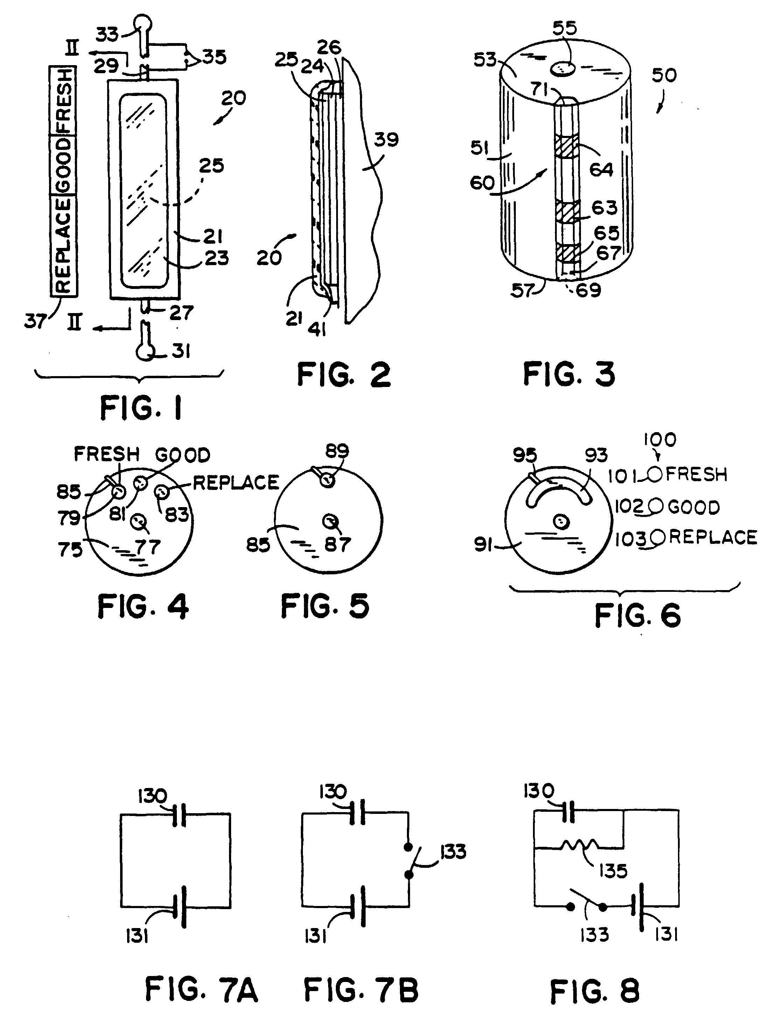

Referring to Fig. 1, a typical electrochromic state of battery charge determining device is shown and indicated generally by the number 20. The device has a transparent cover 21 for containing the several components of the measuring device. The cover 21 has a window or top surface 23 through which the electrochromic material 25 can be viewed. Electrical conductors 27 and 29 extend from each end of the measuring device. The conductor 27 is shown as being of indeterminate length and has a terminal 31 for connection to an external terminal of a battery. Likewise, the conductor 29 is shown of indeterminate length and has a terminal 33 for connection to the opposite terminal of the battery to be measured. A switch is schematically illustrated at 35 which can be used to connect the measuring device 20 across the terminals of a battery being tested. A colour scale 37 can be mounted on the housing of the battery 20 for providing a ready colour comparison for the electrochromic material to determine the state of charge of the battery.

In Fig. 2, the state-of-charge indicator 20 is shown mounted on a battery 39, only a portion of which is shown. In the example shown here, the indicator comprises a cover 21, a counter electrode 26, an ionically conducting electrolyte layer 24, and the electrochromic working electrode which comprises conductive electrode 41 and electrochromic material 25. Counter electrode 26 can be part of the battery label or the battery housing. An electronically conductive electrode 41, which is at least partially optically transparent is coated on the inner surface of cover 21. Alternative modifications of this construction will be apparent to those skilled in the art. For example, one or more electrochromic materials, which can be the same of different materials, can be deposited or coated on both the transparent electrode 41 and counter electrode 26, which can be non-transparent. A further modification involves coating or depositing an electrochromic material 25 on electrode 26 which then becomes the electrochromic working electrode. Further modifications of electrochromic cell construction can be found in Proc. Symposium on Electrochromic Materials, Vol. 90-2, M.K. Carpenter & D. A. Corrigan, Editors, The Electrochemical Society, Princeton, N.J., 1990 or in Large Area Chromogenics: Materials and Devices for Transmittance Control, C. M. Lampest and C. G. Granquist, Editors, Optical Engineering Press, Bellingham, Washington, 1989.

The transparent electronic conductor 41 can be made of a thin metal layer or metal oxide such as doped substoichiometric oxides of indium, tin, cadmium or zinc, for example a fluorine- or antimony-doped tin oxide, as long as the transparent conductive material is compatible with the components of the electrochromic cell. The preparation and application of such transparent electrically conductive films is well-known in the art. A description of such transparent electrical conductors is given in the article by Niall R. Lynam entitled "Transparent Electronic Conductors," Proc. Symposium on Electrochromic Materials, Vol. 90-2, M.K. Carpenter & D. A. Corrigan, Editors, The Electrochemical Society, Princeton, N.J., 1990.

If the electrochromic materials used in the cell have suitable electrical conductivity, they can function both as one of the electrically conductive electrodes in the electrochromic cell and as the material undergoing the redox reaction and exhibiting colour development or change.

The electrolyte materials suitable for use in the electrochromic cell may be inorganic or organic, liquid or solid, or combinations thereof, for example polymer electrolyte materials such as poly-2-acrylamido-2-methyl propanesulfonic acid [poly(AMPS)].

The cover 21 can be made of any of the well-known transparent plastic materials such as polyvinyl chloride, polyvinylidene chloride, polyethylene, polyesters and the like.

The electrochromic material used in the state-of-charge measuring cell can be either an organic or an inorganic material which changes colour or colour intensity, that is, optical absorption, on application of a DC potential. The active material in the electrochromic cell undergoes an oxidation/reduction reaction, commonly referred to as a redox reaction, in order to develop or change colour. The optical absorptivity of the cell is controlled by driving an electrode from one state to another with an external power source.

In some cases, the electrochromic material itself may not undergo the redox reaction but may react with a redox product to produce a colour change. An example of such a system is the production of OH⁻ electrochemically followed by the reaction of the OH⁻ with an organic pH indicating dye to give a colour change. This type of electrochromic system is disclosed in US-A-3,280,701.

Electrochromic materials which show a very large change in extinction coefficient are preferred so that very little electrode material (and hence a very small amount of current) is required to produce a visible colour change. This is in contrast to thermochromic liquid crystal materials which develop a change in colour when a phase change takes place such as going from a solid to a liquid crystal phase.

Inorganic electrochromic materials are represented by WO₃, MoO₃, TiO₂, SnO₂, Cr₂O₃, NiO₂, MnO₂O₃, Ag₂O and Prussian blue which are typical of many well-known solid inorganic electrochromic materials. Such materials have been studied extensively in applications such as optical filters, one-way glass, and variable reflectance mirrors. These materials can be used in a solid form as a coating applied to the transparent conductive coating on the interior of the cover of the device.

### Example 1

A tungsten-containing compound was prepared by electrolysis of an aqueous mixture of potassium tungstate, K₃WO₄, and oxalic acid, H₂C₂O₄.
The compound was deposited by electrolysis onto an optically transparent electronically conductive coating previously deposited on a plastic substrate. This compound can function in the same manner as WO₃ which, as pointed out above, is a well-known electrochromic material but which cannot be readily obtained commercially as a film. The deep blue electrochromic films obtained by the K₂WO₄-H₂C₂O₄ reaction could be cycled in 0.1 N sulfuric acid and appeared to be stable after 200 cycles at 3 Hz between 0.0 to -0.4 volt vs a saturated calomel reference electrode (SCE). This material is colour-less at potentials more positive than -0.1 volt and blue at potentials more negative than -0.3 volt vs SCE. The intensity of the blue colour increased as the potential was decreased to -0.8 volt.

Representative of solid organic electrochromic materials include many macrocyclic and polycyclic materials such as metal phthalocyanines, polypyrrole and polyaniline and common dyes and redox indicators such as naphthol blue black and N,N-diphenylbenzidine. These materials can be applied in solid form as a film on the transparent conductive layer on the inside of the cover of the device.

One such solid material, N-benzylaniline, was selected as an example of an organic material which can be polymerised electrochemically to produce conductive electrochromic films.

### Example 2

The electrochromic electrode was prepared by electrolysis of a 0.1 M N-benzylaniline in 1.0 M phosphoric acid as described by Nguyen and Dao in J. Electrochem. Soc., 136, 2131 (1989), Poly(N-benzylaniline)/(Poly(AMPS))/WO₃ Solid-State Electrochromic Cell. The film prepared by this method could be cycled in 0.05 M sulfuric acid from a deep blue/green at 0.8 volt to a transparent yellow at 0.2 volt vs SCE reference. This electrode was cycled 200 times at 3 Hz without apparent degradation.

The working electrode comprising conductive electrode 41 and electrochromic material 25 of the electrochromic cell shown in Fig. 2 is placed so that it is in contact with an ionically conductive layer 24. This layer 24 is also in contact with the counter electrode. Since the state-of-charge measuring device is to be applied directly to the battery housing or end cover, the counter electrode does not have to be transparent.

The counter electrode 26 in the electrochromic cell is an electronic conductor and can be a metal, a metal oxide or an organic conductor. It can also be made of, or contain a coating of, an electrochromic material, or a combination of the aforementioned materials, for example a coating of an electrochromic material on a metal or a metal oxide. The main requirement for the counter electrode in the electrochromic state-of-charge indicator is that it poise the overall electrochromic cell potential at the correct level for the cell or battery to be tested. The potential may be the result of an electrochemical couple intentionally added or an adventitious impurity.

In addition to the systems using solid electrochromic materials and an electrolyte, as mentioned above, the use of systems employing a single layer functioning as both the electrochromic material and the electrolyte, i.e., electrochemichromic systems, is contemplated. In this modification, the electrochemichromic material includes an anodic component and a cathodic component which undergo oxidation and reduction at the respective electrodes. Both the anodic and cathodic components may contribute to the observed colour change and each electrode may function as a "working electrode" and a "counter electrode." Both electrodes (the electronic conductors at which the electrochemical reactions take place) can be made of the same or different material; however, at least one electrode must be at least partially transparent to permit observation of the visible change in the electrochromic material. Materials such as standard pH or redox indicators, for example phenolphthalein, methyl violet, ethyl red, methylene blue, N,N-diphenylbenzidine, naphthol blue black or N,N-diphenylbenzidine can be used. Further examples of such electrochemichromic systems can be found in US-A-4,902,108. These include N,N,N',N'-tetramethyl-1,4-phenylenediamine; 5,10-dihydro-5,10-dimethylphenazine and N,N',N"-trimethyltriphenazinoxazine. Phenolphthalein, methyl violet or ethyl red provide an indicative colour change through the oxidation and reduction of the solvent (for example H₂O). As described above, the indicator material does not itself undergo a redox reaction but instead reacts with another species, for example protons from water, which are produced by the redox reaction.

When the electrochemichromic materials do not form suitably ionically conductive solutions, a small amount of a compatible electrolyte material can be added. The electrochemichromic solution can also be thickened by using polymeric thickeners such as polymethylmethacrylate, polyethylene oxide, poly-2-acrylamido-2-methyl propanesulfonic acid [poly(AMPS)] or the like.

Referring to Fig. 3, a typical C or D size dry cell battery is shown and indicated generally by the number 50. A typical battery has a cylindrical housing 51 and an end cover 53 in contact with positive terminal 55. The opposite end cover is indicated by 57. On the side of housing 51 is an electrochromic state-of-charge tester indicated by the number 60. The battery testing device can have one or more electrochromic cells, for example three cells, similar to cell 20 of Fig. 1. Cell 64 can have an electrochromic composition contained therein and be poised to indicate a fresh battery. Cell 63 can be of a similar construction, however, having a different electrochromic cell material and being poised to indicate a good condition of the battery, while cell 65 is again of similar construction with a different electrochromic material which indicates that the battery should be replaced. Cell 65 is connected to the negative end cover 57 by means of a conductive strip of material 67 which is folded under and has a contact 69. At the opposite end of the tester, a conductor 71 completes the connection to the positive terminal of the battery. Alternative means of making contact between the electrochromic cell or cells and the battery terminals may be used. For example, one terminal of the electrochromic cell can be in direct contact with one of the battery terminals.

As shown in Fig. 3, the state-of-charge indicator is continuously in contact with the negative and positive external terminals of the battery. When used in such applications, it is preferred to use a solid state electrochromic cell, the layers of which are applied as coatings over the transparent conductor on the interior of the electrochromic cell cover. Solid state electrochromic cells tend to draw substantially less current than solution electrochromic or electrochemichromic materials. When the latter materials are used, it is preferred to use a suitable switch such as switch 35 (Fig. 1) to momentarily connect the battery testing device across the terminals of the battery and, after the reading is complete, the switch should be opened to electrically isolate the battery from the testing device.

Fig. 4 shows the end cover 75 of a battery having a terminal 77 and three electrochromic battery state-of-charge indicating devices 79, 81 and 83. The individual electrochromic cells are already connected to one terminal of the cell. A conductor, such as conductor 85, is electrically insulated from end cover 75 and contacts the opposite electrode within the electrochromic cell and the other external terminal of the battery. A similar contact means can also be provided for cells 81 and 83 (not shown to simplify the drawing). Electrochromic cells 79, 81 and 83 can be substantially similar to cells 64, 63 and 65, as shown in Fig. 3. Again, if a suitable solid state electrochromic cell is used, the cells can be left in continuous contact with the external terminals of the battery. If a solution electrochemichromic cell is used, it is preferred to provide a switch to electrically isolate the testing device until it is actually to be used for testing.

Figs. 5 and 6 are similar to Fig. 4. In Fig. 5, end cover 85 has a single electrochromic cell 87 directly connected to one battery terminal and connected by a suitable circuit means 89 to the opposite terminal of the cell. Fig. 6 shows an end cover 91 with an attached electrochromic cell 93 electrically connected by a suitable conducting means 95 to the opposite terminal of the battery. The electrochromic cells, as shown in Figs. 5 and 6, would preferably have an associated colour scale 100 on the battery label. The colour scale has three coloured portions 101 to indicate a fresh cell, 102 to indicate a good cell and 103 to indicate a cell which should be replaced. The person using either one of the battery state indicating devices of Figs. 5 and 6 merely observes the colour visible in the cell 89 or 93 and compares it with the colour dots of the scale 100 to determine the state of the battery.

As indicated above, the battery state indicating device can be in continuous electrical contact with the external terminals of the battery. Since the testing device does draw current, it is preferred to have some type of an external switch to isolate the testing device from the battery.

The state-of-charge indicating device can be used in either an open circuit or a closed circuit mode. In the closed circuit mode the voltage of the battery is tested under load. Figs. 7A and 7B show a typical open circuit configuration for testing a battery. In Fig. 7A, electrochromic cell 130 is connected in series with battery 131 to be tested. In Fig. 7B, electrochromic cell 130 is again connected to battery 131; however, in this circuit a switch 133 is used to take the electrochromic testing device out of the circuit so as not to discharge the battery. It can be seen in the open circuit test that no load other than the electrochromic cell itself is placed across the terminals of the battery being tested.

Referring to Fig. 8 (invention), this figure represents a typical closed circuit test in which a load resistor 135 is placed across the electrochromic cell 130. The battery 131 is again connected for testing or isolated by a switch 133.

In the open circuit measurement circuit, as shown in Figs. 7A and 7B, the electrochromic cell should be poised to sense the range of voltage produced by the battery 131. When a different voltage range is produced by different types of batteries, different electrochromic materials can be used in the electrochromic cell. In the circuit of Fig. 8, the load resistor 135 can be varied to match the electrochromic cell 130 to the potential produced by the battery 131 in addition to selection of the appropriate electrochromic material. The load resistor 135 can be formed using an electrode having intermediate resistivity such as the transparent electrode on the inside of the cover of the electrochromic device. Such an electrode can be shaped or patterned to vary the resistance and serve as the load along which the potential decreases.

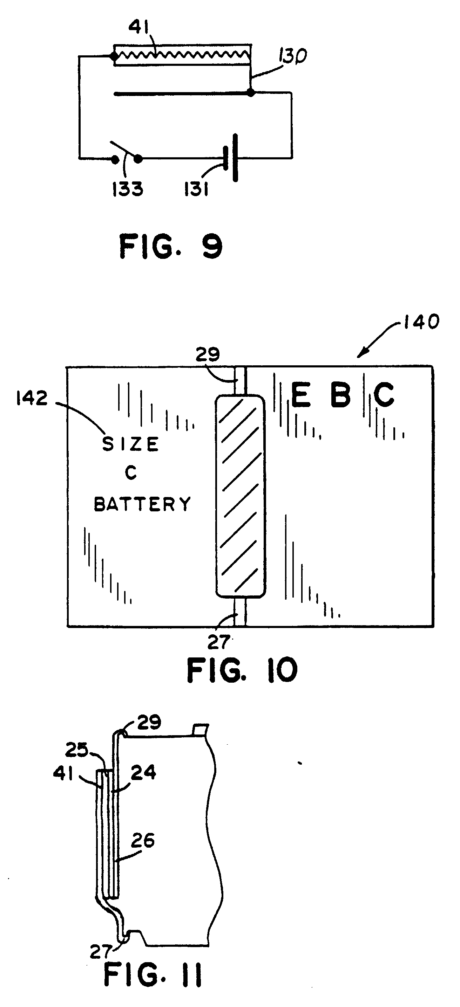

The selection and matching of the voltage range of the electrochromic material can thus be largely avoided by using a testing circuit such as that shown in Fig. 9 in which the resistivity of the electrode, for example the transparent conductive electrode 41, provides the resistive load and, in combination with the electrochromic cell 130, acts a voltage divider. In this cell, the voltage drop across the electrodes of the electrochromic device varies from the closed circuit voltage obtained at the left end of the electrochromic cell, as shown in Fig. 9, to a lower voltage (possibly zero volt) at the other end. With this type of indicator, the state of charge of the cell is determined by the position of the colour in the electrochromic device.

In an additional embodiment of the tester of the present invention, referring to Figs. 10 and 11, the several components making up the electrochromic cell can be applied to the label, indicated generally by 140, during the label printing process where appropriate graphics 142 are applied to the label. For example, the electronically conductive members of the electrochromic cell, for example the conductive electrodes 26 and 41 and their conductive connective members to the battery, can be provided by various means such as by printing a conductive pattern on a label substrate using conductive ink or paint. Alternatively, conductive patterns can be formed on a conductive substrate by etching techniques to remove unwanted portions and by providing (for example by printing) suitable electrical insulation where needed. The solid electrochromic layer 25 can also be printed. The electrolyte layer 24 or electrochemichromic layer (a combination of 25 and 24) can be printed as a solution and then cured or dried. That electrically conductive member, for example member 41, through which the electrochromic material can be viewed can be printed in the form of a grid or other open pattern or can be a vapor-deposited optically transparent material.

The label and tester can be prepared so that one electrode of the tester is in electrical contact with one external terminal of the battery. In an embodiment of the tester where the label is made up of several layers, including a metallic layer, the metallic layer can serve as a conductive element or contact to the electrochromic cell. Either electrical conductor 27 or 29 can be printed on the label so that it terminates near one external terminal of the battery without making electrical contact. The other conductor can be printed so that it will make electrical contact with a terminal of the battery when the label is applied. The open circuit can then be closed by bridging an electrically conductive metal article, even the positive external terminal of a second battery, between the conductor on the label and the end cap to activate the tester.

In the manufacture of the label and battery voltage tester, it is preferred to use a web of the substrate material which can hold many labels and run the web through suitable printing operations or coating operations where the graphics for each label can be applied to the web along with each layer of the tester. After the label and testers have been applied, the web of material can be run through a suitable punch or die cutting operation to separate the individual labels from the web so that the labels can be applied to batteries in the finishing of the battery during the heat shrinking of the label.

From the above description it can be seen that a device can be provided for testing the state of a battery which can be applied to the housing or end covers of the battery and left in place at all times. Since the device does not rely on heat, the thermal mass of the battery will not affect the operation of the device. When the electrical circuit for the testing device is completed, the electrochromic material will change colour indicating the state of the cell.

## Claims

1. An electrochemical cell and a state-of-charge tester (20) therefor, wherein the tester (20) is secured to the cell and comprises electrochromic material (25) which changes colour according to the redox potential to which it is subject and which provides an indication of state-of-charge of the cell thereby, said electrochromic material (25) being sandwiched between electrically conductive layers connectable with opposing terminals of the cell, the outermost layer permitting a user to visually determine the colorimetric state of the electrochromic material, the tester (20) being comprised in a label for the cell and wherein a load resistor (135) is placed across the electrochromic material.

2. A cell and tester (20) according to claim 1, wherein the electrochromic material (25) provides a large surface, or at least a clearly visible surface, so that the user can observe any colour change readily.

3. A cell and tester (20) according to claim 1 or 2, wherein the electrochromic material (25) is flat, or in the form of a film.

4. A cell and tester (20) according to any preceding claim, wherein the electrochromic material (25) is situated at or near the surface of the battery container, or at or near the surface of the battery cover.

5. A cell and tester (20) according to any preceding claim, wherein the electrochromic material (25) is connected to a first terminal by a conductor connecting its underside to the terminal, the conductor preferably being in the form of a wire, and contacting the electrochromic material (25) directly, or via an electrolyte.

6. A cell and tester (20) according to any preceding claim, wherein the upper surface of the electrochromic material (25) is in contact with a suitable electrode and wherein at least part of the electrochromic material (25) is visible through the electrode.

7. A cell and tester (20) according to any preceding claim, further comprising a switch.

8. A cell and tester (20) according to any preceding claim, wherein several different electrochromic materials are used in order to indicate differing states of charge of the cell.

9. A cell and tester (20) according to claim 8, wherein the different indicators are disposed on top of one another in increasing order of activation, so that only one colour is ever visible, but the colour which is visible will indicate the state of charge, or are arrayed side by side, and the number or arrangement of different colours used to indicate state of charge.

10. A cell and tester (20) according to any preceding claim, wherein the indicator goes clear on activation to expose a message, or changes colour and is conformed so as to display a message of that colour, or is beneath a mask which shows a message.

## Patentansprüche

1. Elektrochemische Zelle und Ladezustandsprüfvorrichtung (20) dafür, wobei die Prüfvorrichtung (20) an der Zelle befestigt ist und elektrochromes Material (25) aufweist, das seine Farbe entsprechend dem Redoxpotential ändert, dem es ausgesetzt ist, und das dadurch eine Anzeige des Ladezustands der Zelle liefert, wobei das elektrochrome Material (25) zwischen elektrisch leitenden Schichten angeordnet ist, die mit entgegengesetzten Anschlüssen der Zelle verbunden werden können, wobei die äußerste Schicht ermöglicht, daß ein Benutzer den kolorimetischen Zustand des elektrochromen Materials visuell bestimmt, wobei die Prüfvorrichtung (20) in einem Etikett für die Zelle enthalten ist, und wobei ein Lastwiderstand (135) über das elektrochrome Material gelegt ist.

2. Zelle und Prüfvorrichtung (20) nach Anspruch 1, wobei das elektrochrome Material (25) eine große Oberfläche oder zumindest eine deutlich sichtbare Oberfläche bietet, so daß der Benutzer jede Farbänderung leicht beobachten kann.

3. Zelle und Prüfvorrichtung (20) nach Anspruch 1 oder 2, wobei das elektrochrome Material (25) flach ist oder die Form eines Films hat.

4. Zelle und Prüfvorrichtung (20) nach einem der vorstehenden Ansprüche, wobei das elektrochrome Material (25) an oder in der Nähe der Oberfläche des Batteriebehälters oder an oder in der Nähe der Oberfläche der Batterieabdeckung angeordnet ist.

5. Zelle und Prüfvorrichtung (20) nach einem der vorstehenden Ansprüche, wobei das elektrochrome Material (25) mit einem ersten Anschluß durch einen Leiter verbunden ist, der seine Unterseite mit dem Anschluß verbindet, wobei der Leiter vorzugsweise die Form eines Drahtes hat und das elektrochrome Material (25) direkt oder über einen Elektrolyten kontaktiert.

6. Zelle und Prüfvorrichtung (20) nach einem der vorstehenden Ansprüche. wobei sich die obere Fläche des elektrochromen Materials (25) in Kontakt mit einer geeigneten Elektrode befindet, und wobei zumindest ein Teil des elektrochromen Materials (25) durch die Elektrode hindurch sichtbar ist.

7. Zelle und Prüfvorrichtung (20) nach einem der vorstehenden Ansprüche, die ferner einen Schalter aufweist.

8. Zelle und Prüfvorrichtung (20) nach einem der vorstehenden Ansprüche, wobei mehrere verschiedene elektrochrome Materialien verwendet werden, um unterschiedliche Ladezustände der Zelle anzuzeigen.

9. Zelle und Prüfvorrichtung (20) nach Anspruch 8, wobei die verschiedenen Indikatoren in ansteigender Reihenfolge der Aktivierung übereinander angeordnet sind, so daß stets nur eine Farbe sichtbar ist, aber die sichtbare Farbe den Ladezustand anzeigt, oder wobei die Indikatoren nebeneinander angeordnet sind und die Anzahl oder Anordnung von verschiedenen Farben zur Anzeige des Ladezustands verwendet werden.

10. Zelle und Prüfvorrichtung (20) nach einem der vorstehenden Ansprüche, wobei der Indikator bei der Aktivierung durchsichtig wird, um einen Meldung darzustellen, oder die Farbe ändert und so angepaßt ist, daß er eine Meldung in dieser Farbe anzeigt, oder wobei der Indikator unter einer Maske angeordnet ist, die eine Meldung darstellt.

## Revendications

1. Pile électrochimique et un testeur de l'état de charge (20) de celle-ci, dans lesquels le testeur (20) est fixé à la pile et comprend un matériau électrochromique (25) qui change de couleur selon le potentiel d'oxydoréduction auquel il est soumis et qui donne ainsi une indication de l'état de charge de la pile, ledit matériau électrochromique (25) étant pris en sandwich entre des couches électriquement conductrices pouvant être reliées aux bornes opposées de la pile, la couche la plus extérieure permettant à un utilisateur de déterminer visuellement l'état colorimétrique du matériau électrochromique, le testeur (20) étant compris dans une étiquette de la pile. et dans lesquels une résistance de charge (135) est placée à travers le matériau électrochromique.

2. Pile et testeur (20) selon la revendication 1, dans lesquels le matériau électrochromique (25) offre une grande surface, ou au moins une surface clairement visible, de sorte que l'utilisateur peut observer aisément tout changement de couleur.

3. Pile et testeur (20) selon la revendication 1 ou 2, dans lesquels le matériau électrochromique (25) est plat, ou sous la forme d'un film.

4. Pile et testeur (20) selon l'une quelconque des revendications précédentes, dans lesquels le matériau électrochromique (25) est situé au niveau de la surface du conteneur de pile ou près de celle-ci, ou au niveau de la surface du couvercle de pile ou près de celui-ci.

5. Pile et testeur (20) selon l'une quelconque des revendications précédentes, dans lesquels le matériau électrochromique (25) est relié à une première borne par un conducteur reliant son côté inférieur à la borne, le conducteur étant de préférence sous la forme d'un fil métallique, et contactant directement le matériau électrochromique (25), ou via un électrolyte.

6. Pile et testeur (20) selon l'une quelconque des revendications précédentes, dans lesquels la surface supérieure du matériau électrochromique (25) est en contact avec une électrode appropriée, et dans lesquels au moins une partie du matériau électrochromique (25) est visible par l'intermédiaire de l'électrode.

7. Pile et testeur (20) selon l'une quelconque des revendications précédentes, comprenant en outre un interrupteur.

8. Pile et testeur (20) selon l'une quelconque des revendications précédentes, dans lesquels plusieurs matériaux électrochromiques différents sont utilisés afin d'indiquer différents états de charge de la pile.

9. Pile et testeur (20) selon la revendication 8, dans lesquels les différents indicateurs sont disposés les uns sur les autres dans l'ordre croissant d'activation, de sorte qu'une seule couleur est toujours visible, mais la couleur qui est visible indiquera l'état de charge, ou sont rangés côte à côte, et le nombre ou disposition des différentes couleurs est utilisé pour indiquer l'état de charge.

10. Pile et testeur (20) selon l'une quelconque des revendications précédentes, dans lequel l'indicateur devient clair lors de l'activation pour exposer un message, ou change de couleur et est conformé de façon à afficher un message de cette couleur, ou est sous un cache qui montre un message.
